# EUROPÄISCHE PATENTANMELDUNG

(11) **EP 1 367 876 A1**
(43) Veröffentlichungstag der Anmeldung: **03.12.2003**
(21) Anmeldenummer: 02012021.8
(22) Anmeldetag: 31.05.2002
(51) Int. Cl.: H05K 3/40, H05K 3/32

(54) **Verdrahtungsträger einschliesslich Herstellungsverfahren und damit ausgestattetes elektrisches Gerät**

(71) Anmelder: Festo Ag & Co., 73734 Esslingen (DE); Oechsler AG, 91522 Ansbach (DE); Siemens AG, 80333 München (DE); HAHN-SCHICKARD-GESELLSCHAFT FÜR ANGEWANDTE FORSCHUNG E.V., D-78052 Villingen-Schwenningen (DE)
(72) Erfinder: Maichl, Martin, 73084 Salach (DE); Hoffmann, Markus, 72649 Wolfschlugen (DE); Munz, Gebhardt, 73614 Schorndorf (DE); Weinmann, Michael, Dr., 73655 Plüderhausen (DE); Pöhlau, Frank, Dr., 90762 Fürth (DE); Eberhardt, Wolfgang, Dr., 70597 Stuttgart (DE); Kück, Heinz, Dr., 70437 Stuttgart (DE); Pein, Carsten, 71563 Affalterbach (DE); Schmid, Andreas, 96247 Michelau (DE); Riedel, Michael, 96472 Rödental (DE); Töpfer, Udo, 96247 Michelau (DE); Klump, Stefan, 96215 Lichtenfels (DE); Sestak, Jürgen, 96215 Lichtenfels (DE); Kremer, Hubert, 96349 Steinwiesen (DE)
(74) Vertreter: Abel, Martin, Dipl.-Ing.

(57) **Zusammenfassung**

Es wird ein Verdrahtungsträger (14) vorgeschlagen, der einen aus Kunststoffmaterial bestehenden Trägerkörper (16) besitzt, der an einer ersten Seite eine Verdrahtungsanordnung (15) trägt. Über mindestens eine eine Durchbrechung (24) des Trägerkörpers (16) durchsetzende Durchkontaktierung (26) ist die Verdrahtungsanordnung von der der ersten Seite (17) entgegengesetzten zweiten Seite (25) her kontaktierbar. Die Durchkontaktierung (26) besteht aus einem elektrisch leitfähigen Elastikpfropf (27). Mit der Erfindung wird ferner ein Verfahren zur Herstellung eines solchen Verdrahtungsträgers (14) sowie ein mit einem solchen Verdrahtungsträger (14) ausgestattetes elektrisches Gerät (1) vorgeschlagen.

## Beschreibung

Die Erfindung betrifft einen Verdrahtungsträger, mit einem aus Kunststoffmaterial bestehenden Trägerkörper, der an wenigstens einer ersten Seite eine über elektrische Leiter und/oder Elektronikkomponenten verfügende Verdrahtungsanordnung trägt, die über mindestens eine eine Durchbrechung des Trägerkörpers durchsetzende Durchkontaktierung von der entgegengesetzten zweiten Seite des Trägerkörpers her kontaktierbar oder kontaktiert ist.

Die Erfindung betrifft ferner ein Verfahren zur Herstellung eines Verdrahtungsträgers, der einen aus Kunststoffmaterial bestehenden Trägerkörper aufweist, der an wenigstens einer ersten Seite eine über elektrische Leiter und/oder Elektronikkomponenten verfügende Verdrahtungsanordnung trägt, die über mindestens eine eine Durchbrechung des Trägerkörpers durchsetzende Durchkontaktierung von der entgegengesetzten zweiten Seite des Trägerkörpers her kontaktierbar oder kontaktiert ist.

Die Erfindung betrifft ferner ein mit einem Verdrahtungsträger der vorgenannten Art ausgestattetes elektrisches Gerät, wobei die Definition "elektrisch" auch im Sinne von "elektronisch" zu verstehen ist.

Aus der DE 19722925 C1 geht ein elektrisches Gerät in Gestalt eines elektrischen Anschlusselementes für Elektromagnete von Ventileinheiten hervor, das mit einem Verdrahtungsträger der eingangs genannten Art ausgestattet ist. Der Verdrahtungsträger besitzt einen Trägerkörper mit zwei Seiten, deren eine als Stecker und deren andere als Buchse ausgebildet ist. Den Trägerkörper durchsetzende Durchbrechungen dienen zur elektrischen Verbindung der an den beiden Seiten angeordneten Verdrahtungsanordnungen, indem sie mit Durchkontaktierungen ausgestattet sind. Die Durchkontaktierungen bestehen aus Leiterbahnen, die durch einen nass-chemischen Metallisierungsprozess hergestellt wurden.

Der bekannte Verdrahtungsträger kann unter Verwendung seines Steckers oder seiner Buchse im Rahmen einer Steckverbindung mit einer weiteren Komponente kontaktiert werden. Dies erfordert speziell gestaltete Schnittstellen an beiden Komponenten. Entsprechend hoch ist der Kostenaufwand.

Im Allgemeinen sind bei Verdrahtungsträgern der eingangs genannten Art vor allem Anwendungen problematisch, bei denen mittels der Kontaktierung gleichzeitig auch Bauteiltoleranzen zusammenzufügender Bauteile ausgeglichen werden sollen. In diesem Zusammenhang sind speziell bei verstärkt zur Anwendung kommenden heißgeprägten MID-Verdrahtungsträgern bis heute keine geeignete Durchkontaktierungstechnologien bekannt. Nach dem Kenntnisstand der Anmelder erfolgt derzeit eine Kontaktierung bei gleichzeitigem Toleranzausgleich meist unter Verwendung von Federelementen. In diesem Zusammenhang sind in der Leiterbahntechnologie so genannte Vias bekannt, die die Verbindung zwischen einzelnen Leiterbahnen oder Komponenten herstellen. Mittels leitfähigen Klebstoffen werden Bausysteme zusammengefügt und kontaktiert. Auch hier fehlt es aber an einer Technologie, die gleichzeitig auch einen Toleranzausgleich beim Zusammenfügen mehrerer Komponenten ermöglicht.

Es ist die Aufgabe der vorliegenden Erfindung, Maßnahmen vorzuschlagen, die eine einfache Durchkontaktierung zwischen zwei Seiten eines Trägerkörpers ermöglichen und zudem beim Verbinden mit anderen Bauteilen einen Toleranzausgleich gewährleisten.

Diese Aufgabe wird bei einem Verdrahtungsträger der eingangs genannten Art dadurch gelöst, dass die Durchkontaktierung aus einem elektrisch leitfähigen Elastikpfropf besteht. Bei einem Verfahren der eingangs genannten Art ergibt sich die Lösung der Aufgabe, indem man zur Realisierung der Durchkontaktierung in der betreffenden Durchbrechung einen elektrisch leitfähigen Elastikpfropf vorsieht. Schließlich wird die Aufgabe auch durch ein elektrisches Gerät gelöst, das mit einem Verdrahtungsträger ausgestattet ist, der im vorgenannten Sinne ausgebildet bzw. hergestellt ist.

Die jeweilige Durchkontaktierung besteht somit aus einem elektrisch leitfähigen und zugleich gummielastisch verformbaren Körper, dem Elastikpfropf, der zum einen den elektrischen Signaldurchgang zwischen den beiden Seiten des Trägerkörpers gewährleistet und der zum anderen eine elastische Nachgiebigkeit bereitstellt, die bei der Kontaktierung im Bereich der zweiten Seite des Trägerkörpers einen problemlosen Toleranzausgleich gewährleistet. Dabei können erstmals auch heißgeprägte MID-Verdrahtungsträger mit Durchkontaktierungen versehen werden. Problemlos lassen sich sowohl aktive als auch passive Komponenten und Systeme miteinander verbinden. Der Elastikpfropf kann vorzugsweise unter Abdichtung in der zugeordneten Durchbrechung sitzen, so dass der Verdrahtungsträger auch bei Anwendungen einsetzbar ist, die eine druckdichte Abdichtung zwischen der Innenseite und der Außenseite des Trägerkörpers erfordern. Insgesamt eignet sich der Verdrahtungsträger für die gleichzeitige Kontaktierung, Fixierung, Klemmung und gegebenenfalls auch Abdichtung von mehreren Bauteilen oder Systemen, und zwar unter Gewährleistung eines gleichzeitigen Toleranzausgleiches zwischen den aneinander montierten Komponenten.

Vorteilhafte Weiterbildungen der Erfindung gehen aus den Unteransprüchen hervor.

Bei dem Elastikpfropf handelt es sich zweckmäßigerweise um einen elektrisch leitfähigen Elastomer- oder Gummikörper. Er besteht insbesondere aus gummielastischem Material mit eingebetteten, für die elektrische Leitfähigkeit verantwortlichen Partikeln. Die elektrisch leitfähigen Partikel sind insbesondere Metallpartikel oder metallisierte Kunststoffpartikel.

Der Elastikpfropf kann aus einem Material bestehen, das im flüssigen oder pastösen Zustand in die betreffende Durchbrechung eindosiert wird und das anschließend, zum Erhalt der gewünschten gummielastischen Eigenschaften, aushärtet. Alternativ kann der Elastikpfropf aber auch ein vorgefertigter Elastikkörper sein, der im Rahmen eines Steckprozesses in die betreffende Durchbrechung eingesetzt werden kann.

Für die Kontaktierung mit einer Kontaktfläche einer anderen Komponente ist es von Vorteil, wenn der Elastikpfropf an der zweiten Seite des Trägerkörpers einen über den Trägerkörper vorstehenden, beispielsweise pilzartig oder linsenförmig gestalteten Kontaktierungskopf aufweist. Dieser Kontaktierungskopf könnte auch als Bump bezeichnet werden. Wird der Verdrahtungsträger mit einer anderen Gerätekomponente zusammengefügt, die über eine zu kontaktierende Kontaktfläche verfügt, kann diese Kontaktfläche an den Kontaktierungskopf angepresst werden, der sich dabei verformen kann, so dass bei sicherem elektrischem Kontakt ein relativ großer Toleranzausgleich möglich ist.

Es ist von Vorteil, wenn der Kontaktierungskopf im Vergleich zur Durchbrechung einen größeren Querschnitt besitzt und den Trägerkörper am Rand der Durchbrechung formschlüssig übergreift. Dadurch ist eine optimale Sicherheit gegen ein Hinausdrücken des Elastikpfropfes gegeben, bei Anwendungen, die im Bereich der zweiten Seite des Trägerkörpers einen hohen Druck vorsehen, beispielsweise auf dem Ventilsektor.

Die Verdrahtungsanordnung verfügt zweckmäßigerweise über elektrische Leiter, die in Heißprägetechnik als Leiterbahnstrukturen auf dem Trägerkörper aufgebracht sind. Hier bietet es sich an, den Trägerkörper einschließlich der Verdrahtungsanordnung als MID-Körper ("Molded Interconnect Device") auszubilden. Die Leiterbahnstruktur verfügt im Bereich der durchzukontaktierenden Durchbrechung über einen fluchtenden Kontaktierungsdurchgang, der von einem rohrstutzenartigen Kontaktierungsvorsprung definiert wird, welcher aus umgebogenen Abschnitten der Leiterbahnstruktur besteht und koaxial in die Durchbrechung hineinragt. Er kann insbesondere ringsum an der Wandung der Durchbrechung anliegen. Der Elastikpfropf durchsetzt nun den Kontaktierungsvorsprung, wobei der Kontakt mit diesem die erforderliche elektrische Verbindung mit der Verdrahtungsanordnung gewährleistet.

Zweckmäßigerweise wird der Kontaktierungsvorsprung automatisch gebildet, wenn die aufgeprägte Leiterbahnstruktur im Bereich der zugeordneten Durchbrechung mit einem geeigneten Dorn durchstochen wird. Dabei werden dann Abschnitte der Leiterbahnstruktur in die Durchbrechung hinein umgebogen.

Zum Schutz der Verdrahtungsanordnung ist an der ersten Seite des Trägerkörpers zweckmäßigerweise eine ausgehärtete Vergussmasse angeordnet, in die die Verdrahtungsanordnung eingebettet ist. Soweit elektrische Anschlusskontakte erforderlich sind, können diese aus der Vergussmasse herausragen.

Auf Basis des Verdrahtungsträgers lassen sich praktisch beliebige elektrische Geräte realisieren. Typischerweise ist bei einem solchen elektrischen Gerät an der zweiten Seite des Trägerkörpers des Verdrahtungsträgers eine weitere Gerätekomponente angesetzt, die mindestens eine mit einer elektrischen Komponente elektrisch verbundene Kontaktfläche aufweist, die beim Zusammenfügen mit dem Trägerkörper an den Elastikpfropf angepresst wird, um die gewünschte elektrische Verbindung herzustellen. Auf diese Weise können beispielsweise Ventile oder Sensoren hergestellt werden. Der Verdrahtungsträger kann zusammen mit der Gerätekomponente das Gehäuse des elektrischen Gerätes bilden.

Nachfolgend wird die Erfindung anhand der beiliegenden Zeichnung näher erläutert. In dieser zeigen:
- Fig. 1 bis 6: verschiedene Verfahrensschritte für die Herstellung eines vorteilhaft ausgebildeten erfindungsgemäßen Verdrahtungsträgers und
- Fig. 7: ein unter Verwendung des Verdrahtungsträgers aufgebautes elektrisches Gerät, hier exemplarisch in Gestalt eines Sensors.

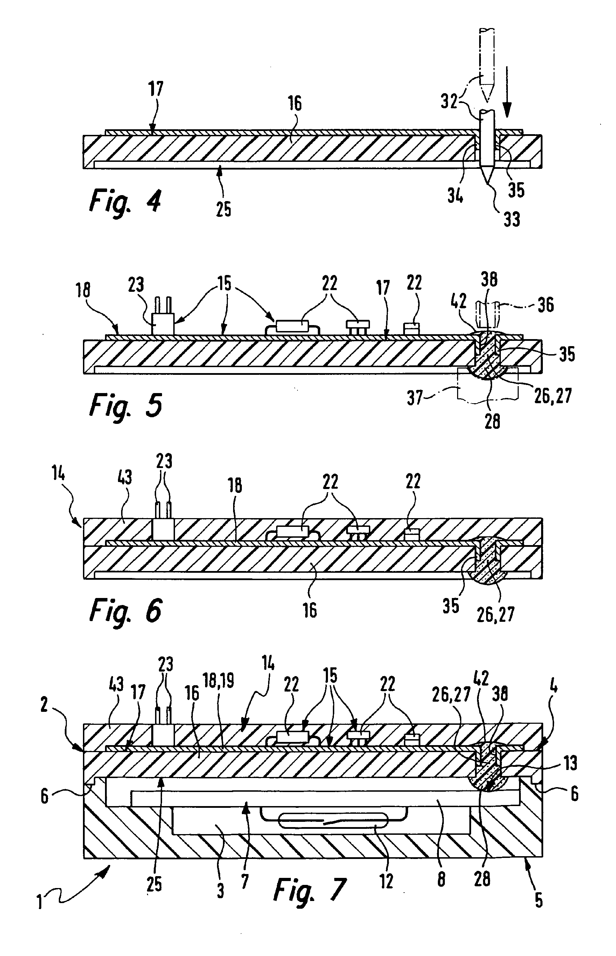

Die Fig. 7 zeigt ein allgemein mit Bezugsziffer 1 bezeichnetes elektrisches Gerät, das von beliebiger Art sein kann, wobei es sich vorliegend um einen Sensor handelt. Der Sensor ist hier ein Positionssensor und kann zur Positionserfassung von sich bewegenden Bauteilen eingesetzt werden.

Das Gerät 1 verfügt über ein Gehäuse 2, das einen Innenraum 3 definiert. Es handelt sich beim Ausführungsbeispiel um ein zweiteiliges Gehäuse mit einem ersten Gehäuseteil 4 und einem zweiten Gehäuseteil 5, wobei diese Gehäuseteile 4, 5 an einem Fügebereich 6 aneinandergesetzt und, beispielsweise durch Verkleben oder Verschweißen, fest miteinander verbunden sind.

Im Innenraum 3 des Gehäuses 2 befindet sich eine elektrische Komponente 7, beim Ausführungsbeispiel eine elektronische Sensoreinheit. Diese enthält eine Platine 8, an der wenigstens ein Sensorelement 12, beispielsweise ein so genannter Reed-Sensor, angeordnet ist.

Die elektrische Komponente 7 ist an dem zweiten Gehäuseteil 5 mittels nicht näher dargestellter Befestigungsmittel fixiert. Sie hat an der dem ersten Gehäuseteil 4 zugewandten Seite wenigstens eine elektrisch leitfähige Kontaktfläche 13, über die elektrische Signale von und zu der elektrischen Komponente 7 übermittelt werden können. Die Kontaktfläche 13 ist beispielsweise Bestandteil einer Leiterbahn der Platine 8.

Das erste Gehäuseteil 4 kann hinsichtlich des Gehäuses 2 eine Deckelfunktion übernehmen.

Die beiden Gehäuseteile 4, 5 bilden zwei aneinander fixierte Gerätekomponenten des elektrischen Gerätes 1. Eine dieser Gerätekomponenten, das erste Gehäuseteil 4, ist von einem Verdrahtungsträger 14 gebildet. Dieser ist mit einer insgesamt mit Bezugsziffer 15 bezeichneten Verdrahtungsanordnung ausgestattet, unter deren Vermittlung die Übertragung elektrischer Signale von und zu der elektrischen Komponente 7 stattfindet.

Im Einzelnen verfügt der Verdrahtungsträger 14 über einen aus Kunststoffmaterial bestehenden Trägerkörper 16, der beim Ausführungsbeispiel plattenartig ausgebildet ist und der an dem Fügebereich 6 die Verbindung zu dem zweiten Gehäuseteil 5 herstellt. Konkret wird hier also der Innenraum 3 von dem zweiten Gehäuseteil 5 und dem als Deckel fungierenden Trägerkörper 16 begrenzt.

Die Verdrahtungsanordnung 15 enthält elektrische Leiter 18, die in Heißprägetechnik als bevorzugt folienartig dünne Leiterbahnstrukturen 19 auf den Trägerkörper 16 aufgebracht sind. Ferner enthält die Verdrahtungsanordnung 15 mehrere mit den elektrischen Leitern 18 verlötete Elektronikkomponenten 22. Darüber hinaus ist die Verdrahtungsanordnung 15 auch noch mit elektrischen Anschlusskontakten 23 ausgestattet, die ebenfalls mit den elektrischen Leitern 18 elektrisch verbunden sind.

Die Verdrahtungsanordnung 15 steht durch den Trägerkörper 16 hindurch mit der mindestens einen Kontaktfläche 13 der elektrischen Komponente 7 in elektrischer Verbindung. Zu diesem Zweck ist der Trägerkörper 16 mit mindestens einer - beim Ausführungsbeispiel zwei Stück - Durchbrechung 24 versehen, die zwischen der ersten Seite 17 und der dem Innenraum 3 zugewandten zweiten Seite 25 des Trägerkörpers durchgeht und die jeweils von einer elektrisch leitenden Durchkontaktierung 26 durchsetzt ist. Die Durchkontaktierung 26 ist zum einen mit der Verdrahtungsanordnung 15 kontaktiert und zum anderen mit der ihr zugeordneten Kontaktfläche 13 der elektrischen Komponente 7. Jeder Durchkontaktierung 26 ist eine eigene Kontaktfläche 13 zugeordnet.

Bei der Durchkontaktierung 26 handelt es sich um einen elektrisch leitfähigen Elastikpfropf 27. Bei diesem handelt es sich um einen elektrisch leitfähigen Elastomer- oder Gummikörper, wobei die gewünschten Eigenschaften - elektrische Leitfähigkeit und zugleich gummielastische Verformbarkeit - dadurch realisiert werden, dass man ein gummielastisches Material verwendet, in das eine Vielzahl elektrisch leitfähiger Metallpartikel eingebettet ist.

Der Elastikpfropf 27 besitzt an der zweiten Seite des Trägerkörpers 16 einen vom Trägerkörper 16 wegragenden, ähnlich einem Bump gestalteten Kontaktierungskopf 28. Bevorzugt hat der Kontaktierungskopf 28 eine pilz- oder linsenförmige Gestalt. Dieser drückt gegen die zugeordnete Kontaktfläche 13 der elektrischen Komponente 7, wobei er zumindest geringfügig elastisch verformt wird, so dass sich auf Grund der Gummielastizität eine gewisse federnde Vorspannung ergibt.

Man wird das elektrische Gerät so auslegen, dass beim Zusammenfügen der beiden Gehäuseteile 4, 5 die Kontaktfläche 13 am zugeordneten Kontaktierungskopf 28 zur Anlage gelangt, bevor die endgültige zusammengefügte Position der beiden Gehäuseteile 4, 5 erreicht wird. Daraus resultiert das gewünschte gegenseitige Anpressen mit entsprechend sicherer, großflächiger elektrischer Verbindung.

Gleichzeitig erreicht man damit einen große Bereiche abdeckenden zuverlässigen Toleranzausgleich. Die elastische Verformbarkeit des Elastikpfropfes 27 stellt ungeachtet der Bauteiltoleranzen eine sichere elektrische Verbindung zur Verfügung. Man erreicht also eine elektrische Kontaktierung mit gleichzeitigem Toleranzausgleich. Hinzu kommt, dass seitens des Verdrahtungsträgers 14 als für die Kontaktierung verantwortliche Komponente unmittelbar eine Durchkontaktierung 26 herangezogen wird, so dass auch insoweit kein gesonderter Herstellungsprozess erforderlich ist.

Der Kontaktierungskopf 28 ist bevorzugt so ausgebildet, dass er im Vergleich zu der von ihm durchsetzten Durchbrechung 24 einen größeren Querschnitt besitzt und den Trägerkörper 16 am Rand der Durchbrechung formschlüssig übergreift. Dadurch wird zum einen die mögliche Kontaktierungsfläche vergrößert. Zum anderen erzielt man aber auch eine formschlüssige Fixierung des Elastikpfropfes 27 am Trägerkörper 16, die ein ungewolltes Entweichen des Elastikpfropfes 27 aus der Durchbrechung 24 zur ersten Seite 17 hin verhindert. Somit ist der Elastikpfropf 27 auch dann sicher verankert, wenn bei einer entsprechenden Anwendung in dem Innenraum 3 ein größerer Druck herrscht als an der Umgebung des elektrischen Gerätes 1.

Zugleich ist der Elastikpfropf 27 in der Lage, einen fluiddichten Kontakt mit dem Trägerkörper 16 einzugehen. Dies lässt sich sehr einfach dadurch erreichen, dass der Elastikpfropf 27 unter elastischer Vorspannung in der Durchbrechung 24 einsitzt und unter Vorspannung an der Wandung der Durchbrechung 24 anliegt oder dass das Material des Elastikpfropfes 27 an dem Trägerkörper 16 fest angeformt ist. Somit kann im Falle einer Überdruckanwendung der vorgenannten Art auch sichergestellt werden, dass durch die Durchbrechung 24 hindurch kein im Innenraum 3 befindliches Fluid entweichen kann.

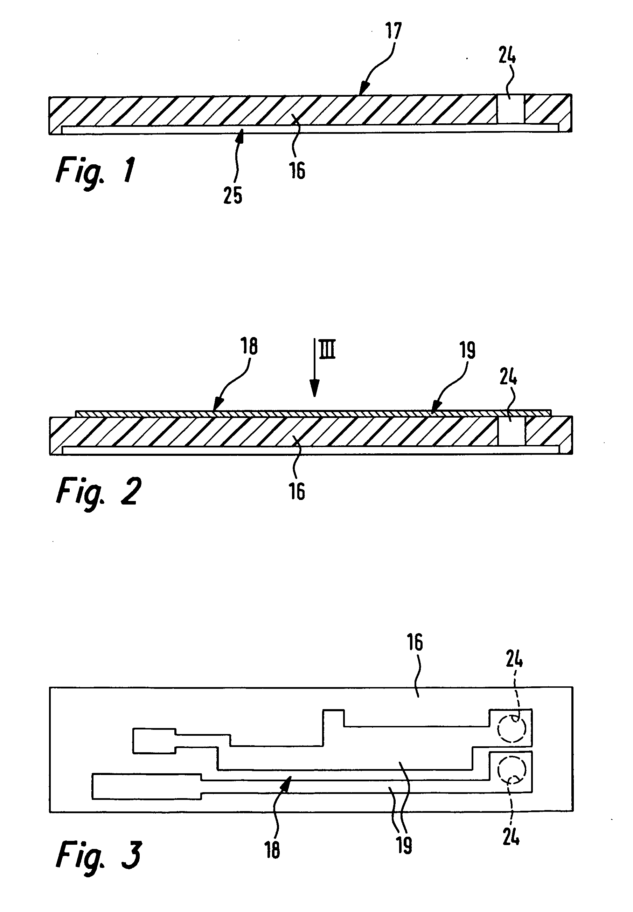

Im Folgenden wird anhand der Fig. 1 bis 6 ein bevorzugtes Herstellungsverfahren für den Verdrahtungsträger 14 erläutert, wobei aber auch weitere vorteilhafte Ausgestaltungsmerkmale des Verdrahtungsträgers 14 aufgezeigt werden.

Bei der Herstellung des Verdrahtungsträgers 14 wird zunächst der in Fig. 1 separat dargestellte Trägerkörper 16 bereitgestellt. Er wird aus Kunststoffmaterial gefertigt, vorzugsweise durch Spritzgießen. Beim Gießvorgang, oder auch anschließend im Rahmen einer spanenden Bearbeitung, wird in den Trägerkörper 16 die gewünschte Anzahl von Durchbrechungen 24 für die Durchkontaktierungen 26 eingebracht.

In einem nächsten Schritt werden die elektrischen Leiter 18 der Verdrahtungsanordnung 15 an der ersten Seite 17 des Trägerkörpers 16 aufgebracht. Dies geschieht zweckmäßigerweise dadurch, dass man eine wunschgemäß gestaltete Leiterbahnstruktur 19 durch Heißprägetechnik an der ersten Seite 17 des Trägerkörpers 16 aufbringt. Diese Leiterbahnstruktur 19 ist dabei so gestaltet, dass sie die jeweils mit einer Durchkontaktierung 26 zu versehende Durchbrechung 24 überdeckt, wie dies aus Fig. 2 und der eine Draufsicht gemäß Pfeil III der Fig. 2 zeigenden Fig. 3 hervorgeht.

Der Trägerkörper 16 bildet somit gemeinsam mit den auf ihm aufgebrachten Komponenten der Verdrahtungsanordnung 15 einen in Prägetechnik realisierten MID-Körper ("Molded Interconnect Device").

In einem nächsten Verfahrensschritt wird die Leiterbahnstruktur 19 im Bereich einer jeweiligen Durchbrechung 24 von der ersten Seite 17 her mit einem geeigneten Dorn 32 durchstoßen (Fig. 4). Dabei taucht der Dorn 32 in die Durchbrechung 24 ein, zweckmäßigerweise bis er an der zweiten Seite 25 wieder austritt.

Damit die Leiterbahnstruktur 19 sauber durchstochen wird, verfügt der Dorn 32 an der Vorderseite zweckmäßigerweise über eine geeignete Spitze 33. Er läuft vorzugsweise kegelförmig zu.

Beim Durchstoßen der Leiterbahnstruktur 19 werden die die Durchstoßungsstelle umgrenzenden Abschnitte 34 der Leiterbahnstruktur 19 nach innen in die Durchbrechung 24 hinein umgebogen, wobei sie sich ringsum an die Wandung der Durchbrechung 24 anlegen. Zweckmäßigerweise entspricht der Durchmesser des Dorns 32 der Differenz aus dem Durchmesser der Durchbrechung 24 und der zweimaligen Dicke der Leiterbahnstruktur 19. Man kann jedoch auch einen etwas größeren Querschnitt des Dorns 32 vorsehen, um eine gewisse Quetschung des umgebogenen Leiterbahnmaterials zu erzielen und somit ein optimales Anschmiegen an die Wandung der Durchbrechung 24 mit gleichzeitiger Glättung eventuell auftretender Falten.

Der Durchstoßungsvorgang ist in Fig. 4 illustriert. Nach dem Durchstoßen wird der Dorn 32 aus der Durchbrechung 24 wieder herausgezogen, wobei die umgebogenen Abschnitte 34 als in die Durchbrechung 24 koaxial hineinragender rohrstutzenartiger Kontaktierungsvorsprung 35 verbleiben. Dieser ist ein einstückiger Bestandteil der Leiterbahnstruktur 19.

Das Durchstoßen der Leiterbahnstruktur 19 zum Zwecke der Herstellung des ringförmigen Kontaktierungsvorsprunges 25 kann auch unmittelbar beim Aufprägen der Leiterbahnstruktur 19 stattfinden.

Als nächstes werden die Elektronikkomponenten 22 und die elektrischen Anschlusskontakte 23 auf der ersten Seite des Trägerkörpers 16 platziert und durch gängige Lötverfahren oder sonstige geeignete Verbindungsmaßnahmen mit der Leiterbahnstruktur 19 elektrisch verbunden und zugleich fixiert. Damit ist die Verdrahtungsanordnung 15 fertiggestellt. Ersichtlich ist dieser Zustand in der Fig. 5.

Als nächstes wird nun der die Durchkontaktierung 26 bildende, elektrisch leitfähige Elastikpfropf 27 in der betreffenden Durchbrechung 24 appliziert. Dies geschieht bevorzugt dadurch, dass man mit Hilfe einer Spritzvorrichtung 36 ein elektrisch leitfähiges Material in flüssigem oder pastösem Zustand von der ersten Seite 17 her dosiert in die betreffende Durchbrechung 24 einbringt. Dabei wird durch ein an der zweiten Seite 25 im Bereich der Austrittsöffnung der Durchbrechung 24 platziertes Formgebungswerkzeug 37 zum einen verhindert, dass die Materialmasse unkontrolliert ausfließt, und zum anderen die für den Kontaktierungskopf 28 gewünschte, bevorzugt kuppenartige Form vorgegeben.

Das derart eindosierte Material lässt man anschließend aushärten, bis es den gewünschten gummielastischen Endzustand erreicht hat. Eventuell wird hierzu Energie zugeführt.

Bei dieser Art der Herstellung des Elastikpfropfes 27 wird eine optimale stoffschlüssige Verbindung zwischen dem Elastikmaterial einerseits und dem Trägerkörper 16 sowie dem Kontaktierungsvorsprung 35 andererseits gewährleistet.

Es besteht jedoch die alternative Möglichkeit, als Elastikpfropf einen separat vorgefertigten Elastikkörper vorzusehen, der über die gewünschten Eigenschaften verfügt und der im Rahmen eines Steckvorganges in die Durchbrechung 24 eingesteckt ist. Hier werden die Abmessungen des Elastikpfropfes 27 zweckmäßigerweise so gewählt, dass er eingepresst werden muss und auf diese Weise ein fester Halt erreicht wird.

Durch den rohrstutzenartigen Kontaktierungsvorsprung 35 wird ein eine verhältnismäßig große axiale Länge aufweisender Kontaktierungsdurchgang 38 definiert, der eine zuverlässige Kontaktierung des Elastikpfropfes 27 mit der Leiterbahnstruktur 19 gewährleistet. Prinzipiell wäre es jedoch auch möglich, den Kontaktierungsdurchgang 38 durch einfaches Ausstanzen oder sonstiges Einbringen eines Loches in die Leiterbahnstruktur 19 im Bereich der Durchbrechung 24 vorzusehen. Um aber auch in diesem Falle eine sichere Kontaktierung zu gewährleisten, ist es empfehlenswert, auch im Bereich der ersten Seite 17 einen, weiteren, Kontaktierungskopf 42 des Elastikpfropfes 27 vorzusehen, der die Leiterbahnstruktur 29 im Umfangsbereich des Kontaktierungsdurchganges 38 übergreift. Eine solche Maßnahme ist jedoch auch bei dem gezeigten Ausführungsbeispiel von Vorteil.

Nachdem der Elastikpfropf 27 installiert ist, wird an der ersten Seite 17 des Trägerkörpers 16 zweckmäßigerweise noch eine Vergussmasse 43 aufgebracht, die im ausgehärteten Zustand eine Schutzhülle für die Verdrahtungsanordnung 15 bildet, wobei lediglich die elektrischen Anschlusskontakte 23 herausragen.

Der somit fertiggestellte Verdrahtungsträger 14 kann nun mit der weiteren Gehäusekomponente 5 vereinigt werden, um das elektrische Gerät 1 zu erhalten. An den elektrischen Anschlusskontakten 23 können wegführende elektrische Leiter angeschlossen werden, die für die Signal- und Energieübertragung zwischen der Verdrahtungsanordnung 15 und einer externen Einrichtung, beispielsweise einem elektronischen Steuergerät, dienen können.

Mit der geschilderten Anordnung und Verfahrensweise lässt sich eine gleichzeitige Kontaktierung, Fixierung, Klemmung und gegebenenfalls Abdichtung von mehreren Bauteilen, Bauelementen und Systemen mittels nur einer Komponente bei gleichzeitigem Toleranzausgleich der einzelnen zu kontaktierenden und miteinander zu verbindenden Komponenten erzielen. Es können nun auch erstmals heißgeprägte MID-Verdrahtungsträger mit Durchkontaktierungen versehen werden. Sowohl aktive als auch passive Komponenten und Systeme lassen sich miteinander verbinden. Etwaige Bauteiltoleranzen gleichen sich durch die elastische Bump-Struktur (Kontaktierungskopf) vollkommen aus. Dies ermöglicht eine kostengünstige Montage, um beispielsweise jegliche aktive oder passive Komponente mit einer MID-Elektronik oder einem Gehäuse zu kontaktieren.

Ein weiterer Vorteil liegt darin, dass durch die Kontaktierungsköpfe (Bumps) eine weitgehende Unabhängigkeit von der räumlichen Struktur der aneinander zu fixierenden und zu kontaktierenden Bauteile erreicht wird. Somit ist es auch unproblematisch, gekrümmte Komponenten zu kontaktieren, zu fixieren und zu klemmen.

## Patentansprüche

1. Verdrahtungsträger, mit einem aus Kunststoffmaterial bestehenden Trägerkörper (16), der an wenigstens einer ersten Seite (17) eine über elektrische Leiter (18) und/oder Elektronikkomponenten (22) verfügende Verdrahtungsanordnung (15) trägt, die über mindestens eine eine Durchbrechung (24) des Trägerkörpers (16) durchsetzende Durchkontaktierung (26) von der entgegengesetzten zweiten Seite (25) des Trägerkörpers (16) her kontaktierbar oder kontaktiert ist, **dadurch gekennzeichnet, dass** die Durchkontaktierung (26) aus einem elektrisch leitfähigen Elastikpfropf (27) besteht.

2. Verdrahtungsträger nach Anspruch 1, **dadurch gekennzeichnet, dass** der Elastikpfropf (27) ein elastisch leitfähiger Elastomer- oder Gummikörper ist.

3. Verdrahtungsträger nach Anspruch 1 oder 2, **dadurch gekennzeichnet, dass** der Elastikpfropf (27) aus gummielastischem Material mit eingebetteten, elektrisch leitfähigen Partikeln, zweckmäßigerweise Metallpartikel oder metallisierte Kunststoffpartikel, besteht.

4. Verdrahtungsträger nach einem der Ansprüche 1 bis 3, **dadurch gekennzeichnet, dass** der Elastikpfropf (27) aus in flüssigem oder pastösem Zustand in die Durchbrechung (24) eindosiertem und anschließend zu gummielastischen Eigenschaften ausgehärtetem Material besteht.

5. Verdrahtungsträger nach einem der Ansprüche 1 bis 3, **dadurch gekennzeichnet, dass** der Elastikpfropf (27) ein im vorgefertigten Zustand in die Durchbrechung (24) eingesetzter Elastikkörper ist.

6. Verdrahtungsträger nach einem der Ansprüche 1 bis 5, **dadurch gekennzeichnet, dass** der Elastikpfropf (27) an der zweiten Seite (25) des Trägerkörpers (16) einen über den Trägerkörper (16) vorstehenden Kontaktierungskopf (28) aufweist.

7. Verdrahtungsträger nach Anspruch 6, **dadurch gekennzeichnet, dass** der Kontaktierungskopf (28) im Vergleich zur Durchbrechung (24) einen größeren Querschnitt besitzt und den Trägerkörper (16) am Rand der Durchbrechung (24) übergreift.

8. Verdrahtungsträger nach einem der Ansprüche 1 bis 7, **dadurch gekennzeichnet, dass** der Trägerkörper (16) mit zumindest Teilen der Verdrahtungsanordnung (15) als MID-Körper ("Molded Interconnect Device") ausgebildet ist.

9. Verdrahtungsträger nach einem der Ansprüche 1 bis 8, **dadurch gekennzeichnet, dass** die Verdrahtungsanordnung (15) über elektrische Leiter (18) verfügt, die in Heißprägetechnik als Leiterbahnstrukturen (19) auf dem Trägerkörper (16) aufgebracht sind.

10. Verdrahtungsträger nach einem der Ansprüche 1 bis 9, **dadurch gekennzeichnet, dass** mindestens ein mit einem Elastikpfropf (27) kontaktierter elektrischer Leiter der Verdrahtungsanordnung (15) als Leiterbahnstruktur (19) an der ersten Seite (17) des Trägerkörpers (16) angeordnet ist und über einen mit der zugeordneten Durchbrechung (24) fluchtenden Kontaktierungsdurchgang (38) verfügt, der von einem von umgebogenen Abschnitten (34) der Leiterbahnstruktur (19) gebildeten und koaxial in die Durchbrechung (24) hineinragenden rohrstutzenartigen Kontaktierungsvorsprung (35) definiert wird, der von dem elektrisch leitfähigen Elastikpfropf (27) durchsetzt ist.

11. Verdrahtungsträger nach Anspruch 10, **dadurch gekennzeichnet, dass** der Kontaktierungsvorsprung (35) von beim lokalen Durchstoßen der Leiterbahnstruktur (19) umgebogenen Abschnitten (34) der Leiterbahnstruktur (19) gebildet ist.

12. Verdrahtungsträger nach einem der Ansprüche 1 bis 11, **dadurch gekennzeichnet, dass** der elastisch leitfähige Elastikpfropf (27) die zugeordnete Durchbrechung (24) des Trägerkörpers (16) mit Dichtkontakt durchsetzt.

13. Verdrahtungsträger nach einem der Ansprüche 1 bis 12, **gekennzeichnet durch** einen plattenartigen Trägerkörper (16), dessen zwei einander entgegengesetzten größerflächigen Seiten die erste und zweite Seite (17, 25) bilden.

14. Verdrahtungsträger nach einem der Ansprüche 1 bis 13, **dadurch gekennzeichnet, dass** auf der ersten Seite (17) des Trägerkörpers (16) eine die Verdrahtungsanordnung (15) umschließende Vergussmasse (43) angeordnet ist, aus der zweckmäßigerweise elektrische Anschlusskontakte (23) herausragen.

15. Verfahren zur Herstellung eines Verdrahtungskörpers, der einen aus Kunststoffmaterial bestehenden Trägerkörper (16) aufweist, der an wenigstens einer ersten Seite (17) eine über elektrische Leiter (18) und/oder Elektronikkomponenten (22) verfügende Verdrahtungsanordnung (15) trägt, die über mindestens eine eine Durchbrechung (24) des Trägerkörpers (16) durchsetzende Durchkontaktierung (26) von der entgegengesetzten zweiten Seite (25) des Trägerkörpers (16) her kontaktierbar oder kontaktiert ist, **dadurch gekennzeichnet, dass** man zur Realisierung der Durchkontaktierung (26) in der betreffenden Durchbrechung (24) einen elektrisch leitfähigen Elastikpfropf (27) vorsieht.

16. Verfahren nach Anspruch 15, **dadurch gekennzeichnet, dass** man zur Realisierung des Elastikpfropfs (27) ein elektrisch leitfähiges Material in flüssigem oder pastösem Zustand in die betreffende Durchbrechung (24) eindosiert und anschließend, zum Erhalt gummielastischer Eigenschaften, aushärten lässt.

17. Verfahren nach Anspruch 16, **dadurch gekennzeichnet, dass** man zur Realisierung des Elastikpfropfs (27) einen vorgefertigten, elektrisch leitfähigen Elastikkörper in der betreffenden Durchbrechung (24) platziert.

18. Verfahren nach einem der Ansprüche 1 bis 17, **dadurch gekennzeichnet, dass** man auf die erste Seite des Trägerkörpers (16) durch Heißprägen eine Leiterbahnstruktur (19) aufbringt, die zunächst die mit einer Durchkontaktierung (26) zu versehende Durchbrechung (24) überdeckt, dass man die Leiterbahnstruktur (19) im Bereich der Durchbrechung (24) von der ersten Seite (17) her mit einem Dorn (32) durchstößt, wobei Abschnitte der Leiterbahnstruktur (19) in die Durchbrechung (24) hinein umgebogen werden, so dass sie einen in die Durchbrechung (24) hineinragenden rohrstutzenartigen Kontaktierungsvorsprung (35) bilden, und dass man dann den Elastikpfropf (27) einbringt, so dass dieser den von dem Kontaktierungsvorsprung (35) umgrenzten Kontaktierungsdurchgang (38) durchsetzt.

19. Elektrisches Gerät, das mit einem Verdrahtungsträger (14) ausgestattet ist, der nach einem der Ansprüche 1 bis 14 ausgebildet und/oder nach einem der Ansprüche 15 bis 18 hergestellt ist.

20. Elektrisches Gerät nach Anspruch 19, **dadurch gekennzeichnet, dass** an der zweiten Seite (25) des Trägerkörpers (16) des Verdrahtungsträgers (14) eine weitere Gerätekomponente (5) angesetzt ist, die mindestens eine mit einer elektrischen Komponente (7) elektrisch verbundene Kontaktfläche (13) aufweist, die unter elastischer Verformung des Elastikpfropfs (27) elastisch leitend an den Elastikpfropf (27) angepresst ist.
